# FASCICULE DE BREVET EUROPEEN

(11) **EP 2 840 616 B1**
(45) Date de publication et mention de la délivrance du brevet: **06.09.2017**
(21) Numéro de dépôt: 14181924.3
(22) Date de dépôt: 22.08.2014
(51) Int. Cl.: H01L 31/107, H01L 31/0232

(54) **Photodiode SPAD à haut rendement quantique**
SPAD-Fotodiode mit hoher Quanteneffizienz
SPAD photodiode with high quantum efficiency

(30) Priorité: 23.08.2013 FR 1358139
(43) Date de publication de la demande: 25.02.2015
(73) Titulaire: Commissariat à l'Energie Atomique et aux Energies Alternatives, 75015 Paris (FR); STMicroelectronics SA, 92120 Montrouge (FR)
(72) Inventeur: Marty, Michel, 38760 Saint Paul de Varces (FR); Frey, Laurent, 38600 Fontaine (FR); Jouan, Sébastien, 38920 Crolles (FR); Boutami, Salim, 38100 Grenoble (FR)
(74) Mandataire: Thibon, Laurent

(56) Documents cités:
- EP-A2- 2 477 231
- US-A- 5 656 835
- US-A1- 2008 170 143
- US-A1- 2011 220 976
- US-A1- 2012 267 694

## Description

### Domaine

La présente demande concerne les diodes photoréceptrices ou photodiodes à semiconducteurs, utilisées par exemple comme photodiodes à photon unique.

### Exposé de l'art antérieur

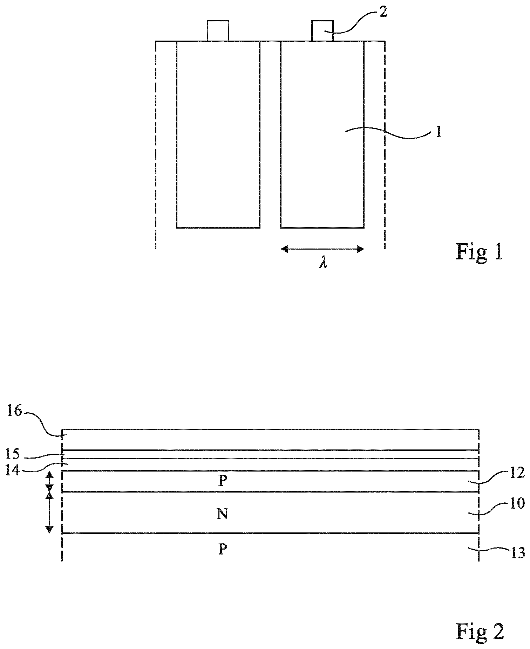

La figure 1 représente de façon simplifiée et partielle deux photodiodes côte à côte d'un réseau de photodiodes constituant par exemple un capteur d'image. Chaque photodiode comprend une zone semiconductrice 1 de conversion de photons en paires électrons-trous. Dans une photodiode complète, il existe des jonctions (non représentées) entre des régions semiconductrices de type opposé pour stocker des électrons/trous, et divers transistors pour transférer les électrons/trous.

La demande de brevet PCT WO2012/032495 expose que, quand les dimensions latérales de la surface éclairée (la surface supérieure en figure 1) d'une photodiode sont très faibles, de l'ordre de la longueur d'onde λ de la lumière que la photodiode est destinée à capter, il se pose un problème pour introduire la lumière dans la photodiode. Ainsi, le rendement quantique de telles photodiodes de très petites dimensions est faible. Cette demande de brevet propose, pour augmenter le rendement quantique de la photodiode, de disposer sur la surface supérieure de celle-ci un plot 2 dont les dimensions latérales sont nettement inférieures aux dimensions latérales de la photodiode.

La figure 2 représente de façon simplifiée et partielle la partie détectrice d'une diode à avalanche à photon unique, couramment désignée par le sigle SPAD (de l'anglais : Single Photon Avalanche Diode). Dans une telle diode, on trouve une structure constituée d'une couche semiconductrice de type N 10 pincée entre deux couches semiconductrices 12 et 13 de type opposé. Le problème est que la couche 10 est, dans les technologies modernes, très mince, d'une épaisseur de l'ordre de seulement 1 à 1,5 µm. C'est dans cette couche 10 que doit se faire la conversion utile des photons en paires électrons-trous, alors que l'on sait que, dans le cas du silicium et pour un rayonnement infrarouge, il faut que la couche dans laquelle doivent se créer les paires électrons-trous ait une épaisseur supérieure à 10 µm, pour espérer obtenir un taux de conversion des photons supérieur à 90 %. Ainsi, le rendement d'une diode SPAD fabriquée par les technologies actuelles est seulement de l'ordre de 5 à 7 %. Pour améliorer ce rendement et ne pas perdre de lumière réfléchie, on dispose au-dessus de la couche supérieure semiconductrice 12 une structure antireflet, comprenant alternativement au moins une couche de matériau à bas indice 14, par exemple de l'oxyde de silicium, et une couche de matériau à plus haut indice 15, par exemple du nitrure de silicium. La couche supérieure 16, de protection, est couramment une couche d'oxyde de silicium.

Ainsi, il se pose un problème pour absorber le maximum de photons possible dans des structures à pixels de petites dimensions telles que celles représentées en figure 1, et dans des structures dans lesquelles la couche de conversion de photons en paires électrons-trous est particulièrement mince, telles que la structure SPAD de la figure 2. Plus généralement, ce problème se pose plus ou moins dans toutes les photodiodes à semiconducteur.

On notera que, dans des photodiodes de type SPAD, une augmentation, même faible, du rendement quantique ou taux d'absorption de la partie utile de la photodiode est en pratique extrêmement importante pour la détection de lumière de faible intensité. Ainsi, un gain de rendement de 1 à 5 % sera considéré comme un gain très important par l'utilisateur.

Par ailleurs, les photodiodes de type SPAD, comme toutes les photodiodes, présentent, en l'absence d'éclairement, un courant d'obscurité qu'il serait souhaitable de réduire autant que possible.

### Résumé

L'objet de l'invention est défini dans la revendication 1. Ainsi, un mode de réalisation prévoit une photodiode de type SPAD dont la surface photoréceptrice est recouverte de bandes entrecroisées formant un treillis en un premier matériau dont les parois latérales sont entourées d'au moins un espaceur en un deuxième matériau d'indice optique distinct de celui du premier matériau, le pas du treillis étant de l'ordre de grandeur de la longueur d'onde de fonctionnement de la photodiode, les premier et deuxième matériaux étant transparents à la longueur d'onde de fonctionnement, le premier matériau étant conducteur et étant couplé à un noeud de connexion.

Selon un mode de réalisation, le premier matériau a un indice n1 différent de l'indice n2 du deuxième matériau, chacun des indices n1 et n2 étant inférieur ou égal à l'indice n_{sc} du semiconducteur constituant la photodiode.

Selon un mode de réalisation, la photodiode est revêtue d'une couche de protection en un matériau d'indice n3 inférieur à n1 et n2.

Selon un mode de réalisation, chacune des bandes du treillis a une largeur de l'ordre du dixième au tiers de la longueur d'onde de fonctionnement de la photodiode.

Selon un mode de réalisation, la photodiode est constituée à partir de silicium, et les bandes du premier matériau sont en silicium polycristallin dopé et sont bordées d'espaceurs en nitrure de silicium.

Selon un mode de réalisation, la couche de protection est en oxyde de silicium.

Un mode de réalisation prévoit un procédé de fabrication d'une photodiode telle que ci-dessus, comprenant une étape préalable de réalisation d'une simulation pour déterminer en fonction des matériaux choisis et de la longueur d'onde de fonctionnement, les dimensions et le pas des bandes du treillis.

Selon un mode de réalisation, les étapes de fabrication des bandes et des espaceurs sont réalisées en même temps que des étapes de fabrication de grilles de transistors MOS.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente très schématiquement, en coupe, une partie de deux photodiodes de petites dimensions ;
la figure 2 représente très schématiquement, en coupe, une partie d'une photodiode de type SPAD ;
la figure 3A représente très schématiquement, en coupe, un exemple de photodiode de type SPAD ;
la figure 3B est une vue de dessus agrandie d'une partie de la figure 3A ;
les figures 4A, 4B et 4C sont des vues en coupe schématiques d'une partie de la région supérieure de photodiodes de différents types ;
la figure 5 est une courbe représentant l'absorption d'une photodiode du type de celle des figures 3A et 3B ou 4C en fonction de la largeur d'espaceurs ;
la figure 6 représente le gain d'absorption dans une photodiode du type à plots et espaceurs par rapport au cas d'une photodiode à plots sans espaceurs, pour diverses valeurs de paramètres de largeur de plot et de distance entre plots ;
les figures 7A et 7B représentent des exemples de modes de réalisation de plots disposés sur des photodiodes ;
la figure 8 représente, en coupe et en perspective, un mode de réalisation d'une photodiode de type SPAD ; et
la figure 9 est un abaque illustrant l'absorption dans une photodiode à treillis du type de celle de la figure 8, pour diverses valeurs de paramètres du treillis.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

Dans le cas d'une diode de type SPAD, dont les dimensions latérales sont couramment de l'ordre de 5 à 20 µm, on pourrait penser à réaliser un réseau de plots mono-matériau du type du plot unique décrit en relation avec la figure 1. On pourrait également, pour améliorer encore le rendement quantique, réaliser une structure dans laquelle chaque plot comprend un plot central revêtu entouré d'un espaceur.

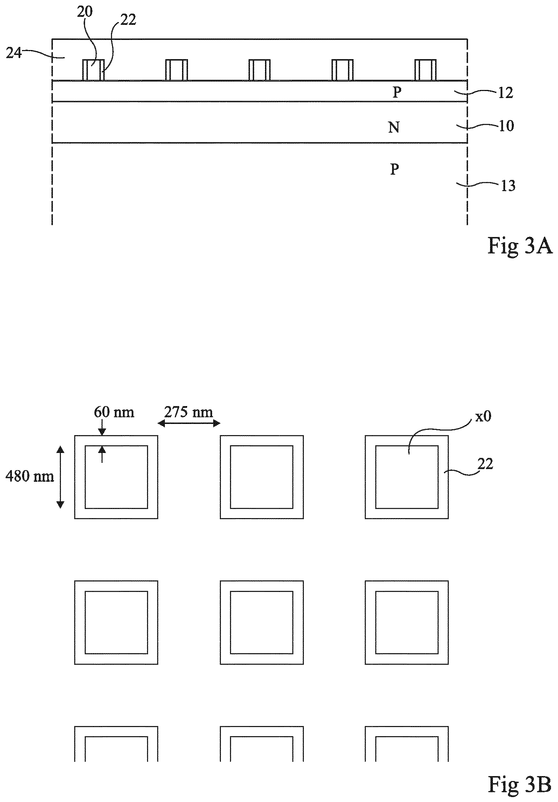

La figure 3A est une vue en coupe d'une diode SPAD de même type que celle de la figure 2, comprenant comme elle une couche 10 de transformation de photons en paires électrons-trous d'un premier type de conductivité, par exemple de type N, encadrée par deux couches 12 et 13 du type de conductivité opposé. La structure est recouverte d'un réseau de plots dont chacun comprend une partie centrale 20 entourée d'un espaceur 22. L'ensemble de la surface supérieure est revêtu d'une couche isolante de protection 24 qui est couramment surmontée d'une couche de filtrage et d'une lentille propre à chaque pixel (non représenté).

Le plot central est en un premier matériau d'indice n1 différent de l'indice n2 du matériau de l'espaceur. La couche 24 est en un matériau d'indice n3 inférieur à n1 et n2. Les matériaux du plot central 20 et des couches 22 et 24 sont transparents à la longueur d'onde de fonctionnement de la photodiode. Chacun des indices n1 et n2 est inférieur à l'indice n_{sc} du semiconducteur 1, l'un des deux pouvant toutefois être égal à n_{sc}. A titre d'exemple, dans le cas où le semiconducteur 1 est du silicium et a une longueur d'onde de fonctionnement de 850 nm, le matériau 20 peut être du silicium polycristallin d'indice n1=3,6 et le matériau 22 peut être du nitrure de silicium stoechiométrique ou non, SiN, d'indice n2=2. Le plot 20 a des dimensions latérales nettement inférieures à la longueur d'onde, par exemple comprises entre le dixième et le tiers de la longueur d'onde à détecter, ou longueur d'onde de fonctionnement, et la couche latérale ou espaceur 22 a une largeur moyenne de l'ordre de 20 à 60 nm. Ce plot peut avoir une forme quelconque, par exemple ronde, carrée, ovale, rectangulaire.

On constate, comme cela sera exposé ci-après, qu'une telle structure, convenablement dimensionnée, augmente de quelques pourcents la quantité de conversion de photons en paires électrons-trous dans la région semiconductrice 10. Ceci est attribué au fait que la présence du plot central 20, en un matériau transparent à la lumière considérée, produit, d'une part des effets de diffraction et que ces effets de diffraction sont accentués par la présence de l'espaceur 22 et/ou, d'autre part, un effet antireflet qui s'améliore également avec la présence de l'espaceur 22. Certains des photons se déplacent alors obliquement, et non plus verticalement, dans le semiconducteur, ce qui augmente leur probabilité d'absorption dans la couche 10.

La figure 3B est une vue de dessus d'un exemple de réalisation. Dans le cas où le semiconducteur est du silicium et où le rayonnement que la photodiode est destinée à accepter a une longueur d'onde λ, le pas des plots peut être égal à 2λ/3 à 20 % près, les dimensions latérales des plots peuvent être comprises entre le dixième et le tiers de la longueur d'onde et la distance entre les plots peut être de l'ordre du quart aux deux tiers de la longueur d'onde. Dans l'exemple représenté où les plots sont en silicium polycristallin, les espaceurs sont en nitrure de silicium, et la longueur d'onde de fonctionnement est de 850 nm, on pourra choisir, à titre d'exemple :
- des dimensions latérales de plots de 400 nm,
- des distances entre plots de 150 nm,
- des largeurs d'espaceurs de 40 nm, et
- des épaisseurs de plots et d'espaceurs de 180 nm.

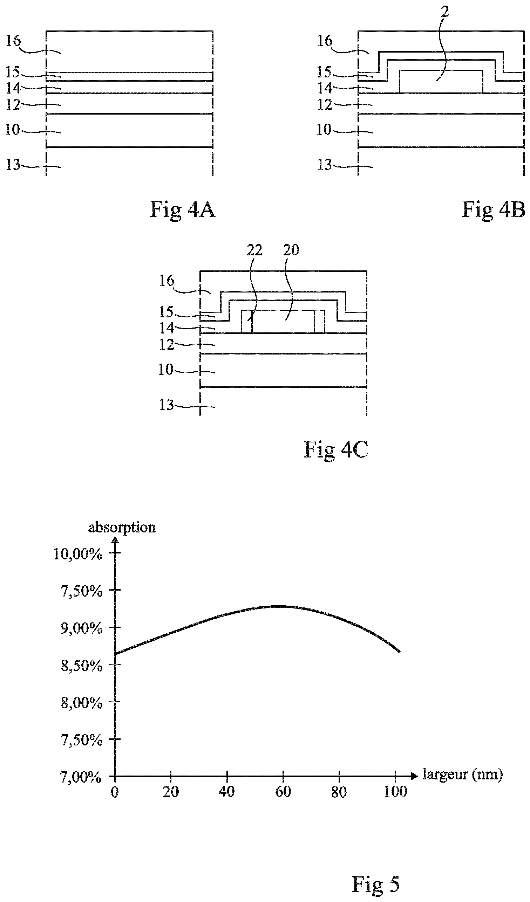

Les figures 4A, 4B, 4C représentent, dans un but comparatif, respectivement, un motif d'une structure sans plots, d'une structure avec plots mono-matériau et d'une structure avec plots et espaceurs. En figure 4A, la structure n'est recouverte d'aucun plot mais seulement d'une couche antireflet, désignée par les mêmes références qu'en figure 2. En figure 4B, la structure est revêtue de plots mono-matériau 2 tels que celui de la figure 1 et est munie d'un revêtement antireflet. En figure 4C, la structure est munie de plots 20 entourés d'espaceurs 22 et est également munie d'un revêtement antireflet.

Des mesures comparatives ont été faites pour chacune des trois structures des figures 4A, 4B et 4C dans le cadre de l'exemple numérique ci-dessus. Le tableau ci-dessous indique, dans chacun des trois cas, pour une photodiode de type SPAD, à motifs périodiques, l'absorption de photons en % dans la couche 10 quand cette couche 10 a une épaisseur de 1,5 µm, l'absorption de photons en % dans la couche 12 quand cette couche 12 a une épaisseur de 1 µm, et le pourcentage de lumière réfléchie.

| | SANS PLOTS | AVEC PLOTS | AVEC PLOTS ET ESPACEURS |
|---|---|---|---|
| Absorption (Si=1,5 µm) | 8 | 8,6 | 9,2 |
| Absorption (Si=1 µm) | 5,7 | 6,3 | 6,7 |
| Réflexion | 6,8 | 4,1 | 1,5 |

La figure 5 est une courbe illustrant l'absorption de photons en % dans la couche 10 pour une photodiode munie de plots pour diverses valeurs de largeur d'espaceur. On voit qu'en l'absence d'espaceurs, cette absorption est de l'ordre de 8,6 % et qu'elle croît à une valeur supérieure à 9 % pour des largeurs de plots comprises entre environ 30 et environ 90 nm, un maximum étant atteint, à environ 9,3 % pour une largeur d'espaceur de l'ordre de 60 nm.

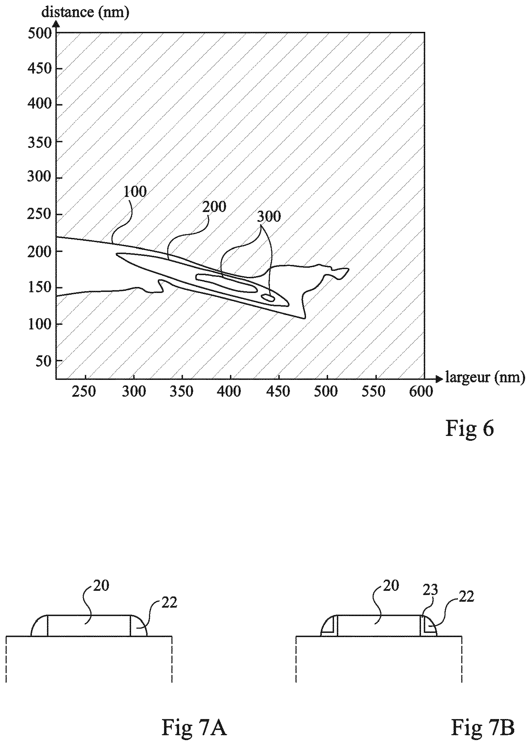

La figure 6 montre que, en fonction de la longueur d'onde et des divers paramètres d'une structure, dont la largeur des espaceurs, le choix de la dimension des plots et de l'intervalle entre plots est crucial pour l'obtention de l'effet recherché d'amélioration de l'absorption des photons. L'abaque de la figure 6 est tracé pour des espaceurs d'une largeur de 40 nm, pour une longueur d'onde de 850 nm, pour une photodiode à base de silicium, et pour des plots en silicium polycristallin bordés d'espaceurs en nitrure de silicium. Les abscisses indiquent des dimensions latérales de plots et les ordonnées des distances entre plots. La courbe 100 délimite une zone à l'intérieur de laquelle l'absorption avec plots et espaceurs est supérieure à l'absorption avec plots sans espaceurs. La courbe 200 délimite une zone à l'intérieur de laquelle l'absorption avec espaceurs est supérieure de 4 % à l'absorption sans espaceurs. La courbe 300 délimite une zone à l'intérieur de laquelle l'absorption avec espaceurs est supérieure de 6 % à l'absorption sans espaceurs. Ainsi, dans ce cas particulier, on voit que le gain d'absorption induit par les espaceurs est maximum quand la largeur des plots est comprise entre environ 350 et environ 450 nm et l'espace entre plots est compris entre environ 150 et environ 180 nm.

De façon générale, l'homme de métier pourra obtenir l'abaque de la figure 6 et réaliser une optimisation des dimensions par des procédés classiques de simulation, en utilisant des programmes de simulation tels que le logiciel DiffractMOD (www.rsoftdesign.com) ou le logiciel Grating Toolbox (www.lighttrans.com). Ainsi, moyennant ce calcul de simulation préalable, l'homme de l'art pourra, sans tâtonnements, réaliser des plots munis d'espaceurs de dimensions convenables pour augmenter le rendement quantique ou absorption de photons d'une photodiode.

Les figures 7A et 7B représentent des exemples de réalisation pratique des plots munis d'espaceurs tels que décrits précédemment. En effet, on notera qu'une structure de type photodiode est généralement associée, dans et sur un même substrat semiconducteur, à des transistors MOS comprenant des grilles dont une partie au moins est en silicium polycristallin, ces grilles étant munies d'espaceurs, couramment en nitrure de silicium. Ainsi, on pourra tout simplement utiliser comme le représente la figure 7A un plot 20 en silicium polycristallin encadré d'espaceurs en nitrure de silicium 22. Selon une variante, illustrée en figure 7B, entre un plot 20 et l'espaceur 22 est prévue une mince couche de matériau intermédiaire 23, comme cela est couramment utilisé dans la réalisation d'espaceurs pour des transistors MOS. Il en résulte que les plots munis d'espaceurs décrits ici peuvent être fabriqués sans modifier une filière technologique classique de fabrication de photodiodes et de transistors CMOS.

On notera également que les plots selon l'invention peuvent reposer sur une très mince couche d'isolant tel que l'isolant de grille de transistors MOS, ayant couramment une épaisseur de l'ordre de seulement quelques nm.

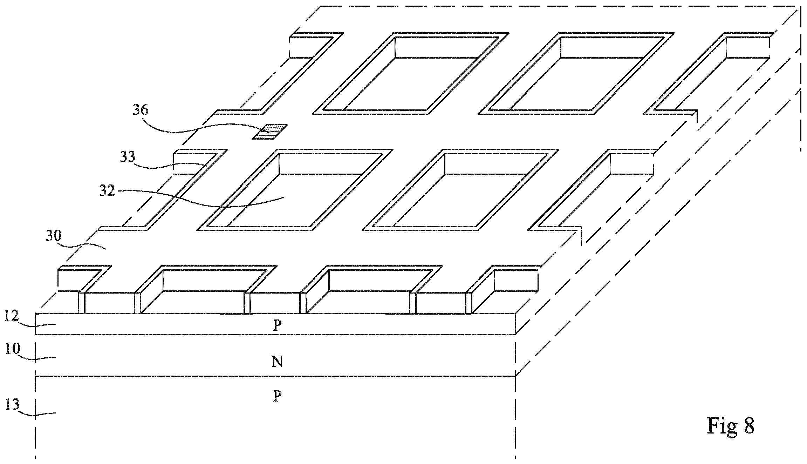

La figure 8 représente un mode de réalisation d'une photodiode de type SPAD. Cette photodiode comprend un substrat de même type que celui représenté en figure 3A à savoir une couche semiconductrice 10 de type N dans laquelle on cherche à transformer des photons en paires électrons-trous. La couche 10 est encadrée de couches 12 et 13 du type de conductivité opposé. Au dessus de la couche 10 est formé un treillis qui est le complémentaire du réseau de plots représenté en figure 3B. Ce treillis comprend des bandes entrecroisées 30 en un premier matériau délimitant entre elles des évidements 32. Chacune des bandes 30 est bordée d'un espaceur 33. Ainsi, les dimensions des évidements 32 correspondent aux dimensions des plots centraux 20 de la figure 3B. Les relations d'indices entre le matériau des bandes 30 et le matériau des espaceurs 33 sont les mêmes que celles exposées en relation avec les figures 3A et 3B. De plus, bien que cela n'apparaisse pas en figure 8 pour la simplification de la représentation, la structure, comme celle de la figure 3A, est de préférence revêtue d'une couche de protection à plus faible indice que les autres éléments de la structure.

Selon une caractéristique supplémentaire du mode de réalisation de la figure 8, les bandes en treillis 30 sont en un matériau conducteur, par exemple en silicium polycristallin dopé, de type N ou de type P selon les technologies utilisées. Au moins un élément de liaison 36 est prévu sur et en contact avec une partie au moins des bandes 30 pour permettre une connexion de ces bandes à un potentiel de polarisation. Bien que cet élément de liaison 36 soit représenté sur le treillis de la figure 8, cet élément de liaison sera de préférence prévu sur des prolongements de ces bandes en dehors de la zone utile de la photodiode pour ne pas perturber son fonctionnement.

Le fait de relier les bandes 30, qui constituent une électrode transparente, à une tension de polarisation permet de repousser les porteurs de charge qui tendraient à se rapprocher de la surface supérieure de la photodiode et à créer un courant d'obscurité par recombinaison.

Ainsi, les bandes 30 ont la double fonction d'amélioration du rendement quantique de la diode et de réduction de son courant d'obscurité.

L'utilisation de programmes de simulation tels que ceux indiqués précédemment, montre que la structure de la figure 8, sensiblement complémentaire de celle des figures 3A et 3B, a des caractéristiques encore plus avantageuses d'augmentation du rendement quantique de la photodiode SPAD sous-jacente.

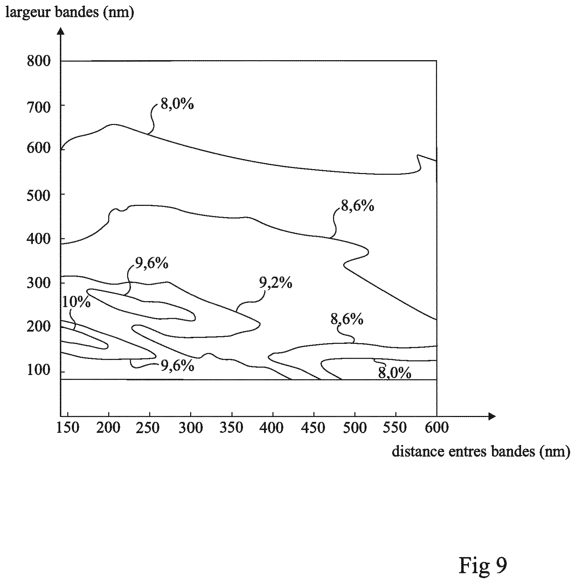

La figure 9 est un abaque illustrant l'absorption dans une photodiode à treillis du type de celle de la figure 8, pour diverses valeurs de paramètres du treillis. La figure 9 montre que, en fonction de la longueur d'onde et des divers paramètres de la structure, le choix de la largeur des bandes (incluant les espaceurs) et de l'intervalle entre bandes est crucial pour l'obtention de l'effet recherché d'amélioration de l'absorption des photons.

L'abaque de la figure 9 est tracé pour des espaceurs d'une largeur de 40 nm, pour une longueur d'onde de 850 nm, pour une photodiode à base de silicium, et pour des bandes 30 en silicium polycristallin bordées d'espaceurs 33, les évidements 32 étant remplis d'oxyde de silicium. Les abscisses indiquent des distances entre bandes du treillis et les ordonnées des dimensions latérales de bandes (incluant les espaceurs).

Dans cette figure on a indiqué des zones où l'absorption est, respectivement, supérieure à 8,0 %, 8,6 %, 9,2 %, 9,6 %, et 10 %.
- La zone où l'absorption est supérieure à 8,0 % est comprise sous la courbe supérieure marquée "8,0 %" et au dessus et à gauche de la courbe inférieure marquée "8,0 %". On notera que dans cette zone l'absorption est supérieure à celle d'une photodiode sans plots ni espaceurs.
- La zone où l'absorption est supérieure à 8,6 % est comprise sous la courbe supérieure marquée "8,6 %" et au dessus et à gauche de la courbe inférieure marquée "8,6 %". On notera que dans cette zone l'absorption est supérieure à celle d'une photodiode avec plots sans espaceurs.
- La zone où l'absorption est supérieure à 9,2 % est comprise à l'intérieur de la courbe marquée "9,2 %". On notera que dans cette zone l'absorption est supérieure à celle d'une photodiode avec plots et espaceurs, du type de celle représentée en figures 3A et 3B.
- Dans deux zones, marquées "9,6 %", l'absorption est supérieure à 9,6 %.
- Dans une zone, marquée "10 %", l'absorption est supérieure ou égale à 10 %.

Ainsi, dans ce cas particulier, on voit que le gain d'absorption induit par la structure en treillis est maximum quand la largeur des bandes est comprise entre environ 180 et environ 300 nm et la distance entre bandes est comprise entre moins de 150 et environ 300 nm.

Tous les avantages et spécificités exposés en relation avec l'exemple des figures 3A et 3B s'appliquent au mode de réalisation de la figure 8.

Bien entendu, la présente invention est susceptible de nombreuses variantes et modifications en ce qui concerne notamment les matériaux utilisés qui peuvent être tous matériaux choisis, à condition qu'ils soient transparents à la longueur d'onde de fonctionnement et qu'ils respectent les relations exposées précédemment entre les indices n1, n2, n3 et l'indice n_{sc} du semiconducteur de la photodiode. Si la technologie amène à utiliser d'autres matériaux que du silicium polycristallin, du nitrure de silicium et de l'oxyde de silicium, des programmes de simulation tels que ceux indiqués précédemment permettront de déterminer les dimensions optimales et le pas des bandes à utiliser, sans tâtonnements.

## Revendications

1. Photodiode de type SPAD dont la surface photoréceptrice est recouverte de bandes entrecroisées (30) formant un treillis en un premier matériau dont les parois latérales sont entourées d'au moins un espaceur (33) en un deuxième matériau d'indice optique distinct de celui du premier matériau, le pas du treillis étant de l'ordre de grandeur de la longueur d'onde de fonctionnement de la photodiode, les dimensions du treillis et de l'espaceur étant choisies de sorte qu'elles impliquemt des effets de diffractions qui augmentent l'absorption de la photodiode, les premier et deuxième matériaux étant transparents à la longueur d'onde de fonctionnement, le premier matériau étant conducteur et étant couplé à un noeud de connexion (36).

2. Photodiode selon la revendication 1, dans laquelle le premier matériau a un indice n1 différent de l'indice n2 du deuxième matériau, chacun des indices n1 et n2 étant inférieur ou égal à l'indice n_{sc} du semiconducteur constituant la photodiode.

3. Photodiode selon la revendication 2, revêtue d'une couche de protection en un matériau d'indice n3 inférieur à n1 et n2.

4. Photodiode selon la revendication 1 ou 2, dans laquelle chacune des bandes du treillis a une largeur de l'ordre du dixième au tiers de la longueur d'onde de fonctionnement de la photodiode.

5. Photodiode selon l'une quelconque des revendications 1 à 4, constituée à partir de silicium, dans laquelle les bandes du premier matériau sont en silicium polycristallin dopé et sont bordées d'espaceurs en nitrure de silicium.

6. Photodiode selon les revendications 3, 4 et 5, dans laquelle la couche de protection est en oxyde de silicium.

7. Procédé de fabrication d'une photodiode selon l'une quelconque des revendications 1 à 6, comprenant une étape préalable de réalisation d'une simulation pour déterminer en fonction des matériaux choisis et de la longueur d'onde de fonctionnement, les dimensions et le pas des bandes du treillis.

8. Procédé selon la revendication 7, dans lequel les étapes de fabrication des bandes et des espaceurs sont réalisées en même temps que des étapes de fabrication de grilles de transistors MOS.

## Patentansprüche

1. Eine Photodiode vom SPAD-Typ, deren Licht aufnehmende Oberfläche mit sich kreuzenden Streifen (30) bedeckt ist, die ein Gitter aus einem ersten Material bilden, wobei ihre Seitenwände mit wenigstens einem Abstandselement (33) aus wenigstens einem zweiten Material umgeben sind, das einen optischen Index hat, der sich von dem ersten Material unterscheidet, wobei ein Abstand des Gitters in der Größenordnung der Betriebswellenlänge der Photodiode ist, wobei die Größen bzw. Abmessungen des Gitters und das Abstandselement so ausgewählt sind, dass sie Diffraktionseffekte implizieren, die die Absorption der Photodiode erhöhen, wobei die ersten und zweiten Materialien transparent für die Betriebswellenlänge sind, wobei das erste Material leitend ist und an einen Verbindungsknoten (36) gekoppelt ist.

2. Photodiode nach Anspruch 1, wobei das erste Material einen Index n1 hat, der sich von dem Index n2 des zweiten Materials unterscheidet, wobei jeder der Indizes n1 und n2 kleiner als oder gleich einem Index n_{sc} des Halbleiters ist, der die Photodiode bildet.

3. Photodiode nach Anspruch 2, die mit einer Schutzschicht beschichtet ist, die aus einem Material mit einem Index n3 hergestellt ist, der niedriger ist als n1 und n2.

4. Photodiode nach Anspruch 1 oder 2, wobei jeder der Streifen des Gitters eine Breite in dem Bereich von einem Zehntel bis einem Drittel der Betriebswellenlänge der Photodiode hat.

5. Photodiode nach einem der Ansprüche 1 bis 4, basierend auf Silizium, wobei die Streifen des ersten Materials aus dotiertem Polysilizium hergestellt sind und mit Siliziumnitridabstandselementen begrenzt bzw. eingefasst sind.

6. Photodiode nach Anspruch 3, 4 und 5, wobei die Schutzschicht aus Siliziumoxid hergestellt ist.

7. Ein Verfahren zum Herstellen der Photodiode nach einem der Ansprüche 1 bis 6, das einen früheren Simulationsschritt aufweist, zum Bestimmen der Abmessungen und der Abstände der Gitterstreifen gemäß den ausgewählten Materialien und der Betriebswellenlänge.

8. Verfahren nach Anspruch 7, wobei die Schritte der Herstellung der Streifen und der Abstandselemente gleichzeitig wie die Herstellungsschritte der MOS-Transistor-Gatter bzw. MOS-Transistor-Gates durchgeführt werden.

## Claims

1. A SPAD-type photodiode having its light-receiving surface covered with interlaced strips (30) forming a lattice of a first material having its lateral walls surrounded with at least one spacer (33) of at least one second material having an optical index different from the first material, the pitch of the lattice being in the order of magnitude of the operating wavelength of the photodiode, the sizes of the lattice and of the spacer being chosen so that it implies diffraction effects that increase the absorption of the photodiode, the first and second materials being transparent to the operating wavelength, the first material being conductive and being coupled to a connection node (36).

2. The photodiode of claim 1, wherein the first material has an index n1 different from index n2 of the second material, each of indexes n1 and n2 being lower than or equal to index n_{sc} of the semiconductor forming the photodiode.

3. The photodiode of claim 2, coated with a protection layer made of a material of index n3 lower than n1 and n2.

4. The photodiode of claim 1 or 2, wherein each of the strips of the lattice has a width in the range from one tenth to one third of the operating wavelength of the photodiode.

5. The photodiode of any of claims 1 to 4, based on silicon, wherein the strips of the first material are made of doped polysilicon and are bordered with silicon nitride spacers.

6. The photodiode of claims 3, 4, and 5 wherein the protection layer is made of silicon oxide.

7. A method of manufacturing the photodiode of any of claims 1 to 6, comprising a prior simulation step to determine according to the selected materials and to the operating wavelength the dimensions and the pitch of the lattice strips.

8. The method of claim 7, wherein the steps of manufacturing the strips and the spacers are carried out at the same time as manufacturing steps of MOS transistor gates.
